# FASCICULE DE BREVET EUROPEEN

(11) **EP 1 365 271 B1**
(45) Date de publication et mention de la délivrance du brevet: **12.10.2005**
(21) Numéro de dépôt: 03101454.1
(22) Date de dépôt: 21.05.2003
(51) Int. Cl.: G02B 26/08, H01H 59/00, B81B 3/00

(54) **Dispositif d'actionnement électrostatique miniature et installation comprenant de tels dispositifs**
Elektrostatischer Mikroantriebsvorrichtung und Installation mit solchen Vorrichtungen
Electrostatic microactuator device and installation with such devices

(30) Priorité: 23.05.2002 FR 0206293
(43) Date de publication de la demande: 26.11.2003
(73) Titulaire: COMMISSARIAT A L'ENERGIE ATOMIQUE, 75752 Paris Cedex 15 (FR); CENTRE NATIONAL DE LA RECHERCHE SCIENTIFIQUE (CNRS), 75016 Paris (FR)
(72) Inventeur: Stadler, Eric, 38700 La Tronche (FR); Charton, Julien, 38100, Grenoble (FR)
(74) Mandataire: Poulin, Gérard

(56) Documents cités:
- EP-A- 0 419 853
- DE-A- 4 119 955
- US-A- 5 808 780
- US-A- 6 025 951
- US-A- 6 115 231

## Description

### DOMAINE TECHNIQUE

La présente invention se rapporte à un dispositif d'actionnement électrostatique miniature apte à générer des mouvements dans une direction déterminée, ces mouvements étant obtenus par l'intermédiaire d'au moins un couple d'électrodes dont l'une d'entre elles est susceptible d'être déplacée par rapport à l'autre, sous l'effet d'une force électrostatique s'exerçant entre les deux électrodes soumises à une différence de potentiel.

L'invention a également trait à une installation comprenant de tels dispositifs d'actionnement électrostatique miniatures, les dispositifs étant juxtaposés les uns aux autres.

A titre d'exemple, l'invention trouve une application en tant que composant du type MEMS (de l'anglais « Micro Electro Mechanical System ») dans des domaines comme l'astrophysique ou l'ophtalmologie, notamment en vue de réaliser l'actionnement d'instruments optiques tels que des micro-miroirs déformables en continu.

Par ailleurs, l'invention s'applique également à tout autre micro-système nécessitant d'être actionné en translation selon une direction déterminée.

### ETAT DE LA TECHNIQUE ANTERIEURE

Dans ce domaine technique, plusieurs réalisations ont déjà été proposées.

En effet, on connaît tout d'abord de l'art antérieur des dispositifs d'actionnement électrostatique miniatures classiques, comprenant une électrode fixe et une électrode mobile située parallèlement et à distance de l'électrode fixe.

Lors de l'application d'une tension électrique entre les deux électrodes, une force électrostatique est générée et provoque le déplacement de l'électrode mobile par rapport à l'électrode fixe, selon une direction sensiblement perpendiculaire au plan dans lequel se trouve l'électrode fixe. Ainsi, lors de la mise en oeuvre d'un tel dispositif, le déplacement obtenu permet de générer des mouvements de translation dans la direction déterminée, correspondant dans ce cas à la direction de déplacement de l'électrode mobile.

Cependant, ce type de dispositif d'actionnement classique présente de nombreux inconvénients perturbant fortement son fonctionnement. Ces inconvénients sont notamment rencontrés lors de la mise en oeuvre d'un tel dispositif afin d'actionner un micro-miroir déformable en continu.

Parmi ces inconvénients, on peut tout d'abord citer le phénomène de plaquage brusque (de l'anglais « pull-in ») auquel ce type de dispositif est soumis. En effet, les dispositifs électrostatiques classiques présentent habituellement une instabilité caractéristique se traduisant par un plaquage brusque de l'électrode mobile contre l'électrode fixe, lorsque la tension appliquée entre les deux électrodes dépasse une certaine valeur. En conséquence, la course maîtrisée de l'électrode mobile correspond à une distance largement restreinte par rapport à la distance initiale séparant les deux électrodes n'ayant pas encore été soumises à une différence de potentiel. Ainsi, il en résulte que les dispositifs classiques ne permettent pas de générer des mouvements maîtrisés de fortes amplitudes dans la direction déterminée.

De plus, un autre inconvénient afférent à ce type de dispositif concerne l'absence de linéarité entre la tension appliquée et le déplacement engendré de l'électrode mobile. Cette contrainte rencontrée sur toute la plage d'utilisation rend la commande du dispositif très difficilement réalisable, ceci étant bien entendu au détriment de la précision de l'actionnement du micro-système à piloter.

Enfin, il est à préciser que la force développée par le déplacement de l'électrode mobile reste relativement faible, notamment par rapport à une force requise moyenne permettant d'actionner correctement un micro-miroir déformable en continu.

Pour faire face à ces divers problèmes, il a été proposé dans l'art antérieur un autre dispositif d'actionnement électrostatique miniature, décrit dans le document EP-A-0 592 469, ainsi que dans le document DE-A-41 19 955.

Les documents mentionnés ci-dessus décrivent un dispositif d'actionnement miniature comportant une membrane du type diaphragme et un support sur lequel repose une couche électriquement conductrice, ainsi qu'une couche isolante interposée entre le diaphragme et la couche conductrice. Dans un état non-activé, c'est-à-dire lorsque aucune tension électrique n'est appliquée entre le diaphragme également électriquement conducteur et la couche conductrice, seules les extrémités du diaphragme sont plaquées contre la couche conductrice. L'autre partie du diaphragme est alors située à distance de la couche conductrice, de manière à définir un espace vide avec celle-ci.

Lors de l'activation du dispositif, réalisée par l'application d'une tension entre les deux éléments électriquement conducteurs, la partie du diaphragme située à distance de la couche conductrice est apte à se plaquer progressivement contre cette dernière, de manière symétrique par rapport à une partie centrale du diaphragme et depuis les extrémités de celui-ci. Notons que la symétrie du dispositif entraîne un déplacement en translation de la partie centrale du diaphragme, selon une direction sensiblement perpendiculaire à la couche conductrice.

Le dispositif d'actionnement décrit ci-dessus est avantageux dans la mesure où le diaphragme utilisé est apte à être plaqué progressivement contre la couche conductrice de manière à rendre le volume de l'espace vide quasiment nul, sans pour autant rencontrer de phénomène du type « pull-in » provoquant le plaquage brusque du diaphragme contre la couche conductrice. De cette façon, la course maîtrisée de la partie centrale du diaphragme apte à être animée d'un mouvement selon la direction déterminée correspond approximativement à la distance initiale séparant la partie centrale du diaphragme et la couche conductrice. Cette course est ainsi totalement optimisée par rapport à la conception d'un tel dispositif.

De plus, des expériences effectuées sur ce dispositif ont démontré l'existence d'une linéarité entre le déplacement de la partie centrale du diaphragme et la tension appliquée entre les éléments conducteurs, cette relation linéaire ayant été observée sur une grande plage d'utilisation du dispositif.

Par ailleurs, comme mentionné ci-dessus, le diaphragme est susceptible de se plaquer progressivement contre la couche conductrice depuis les extrémités de ce diaphragme, la surface de plaquage entre le diaphragme et la couche conductrice étant fonction de la tension électrique appliquée entre ces deux éléments. De cette manière, à tout moment durant l'activation du dispositif, on peut remarquer qu'une portion du diaphragme non-encore plaquée et située directement dans le prolongement d'une partie plaquée est extrêmement rapprochée de la couche conductrice. Or la force développée par le déplacement du diaphragme étant inversement proportionnelle au carré de la distance séparant le diaphragme et la couche conductrice, cette force est ainsi très importante dans la plage d'utilisation du dispositif.

Il est précisé que le phénomène de plaquage progressif des deux éléments conducteurs, connu notamment sous la dénomination d'« effet zipping », est également décrit dans le document intitulé « A New Electrostatic Actuator providing improved Stroke length and force, MEMS'92, J. Branebjerg ; P. Gravesen ».

Bien que remédiant aux problèmes relatifs aux dispositifs d'actionnement électrostatique classiques, le dispositif miniature décrit dans le document EP-A-0 592 469 présente cependant un inconvénient majeur.

En effet, après une phase d'activation d'un tel dispositif ayant provoqué le plaquage du diaphragme contre la couche conductrice, la seule action de diminution de la tension appliquée entre ces deux éléments ne suffit pas pour replacer le diaphragme dans sa position initiale. Ainsi, pour pouvoir pallier cet inconvénient, le dispositif comporte également des moyens d'injection de gaz sous-pression à l'intérieur de l'espace vide formé entre le diaphragme et la couche conductrice. De cette manière, lors d'une injection de gaz sous-pression dans l'espace vide, une force est appliquée sur l'ensemble du diaphragme, permettant alors à ce dernier de reprendre sa forme et sa position initiale.

Néanmoins, un tel agencement complique fortement la conception de ce type de dispositif, de sorte que les coûts relatifs à la fabrication et à la mise en oeuvre des moyens d'injection de gaz sous-pression sont largement démesurés par rapport au coût global de l'ensemble du dispositif.

De plus, en raison du mode de fonctionnement des moyens permettant de remettre en place le diaphragme dans sa position initiale, celui-ci et/ou la couche isolante doit nécessairement être étanche en vue d'assurer une bonne coopération avec les moyens d'injection de gaz sous-pression, cela engendrant naturellement des contraintes dans la géométrie et dans le choix des matériaux utilisables pour réaliser le diaphragme et/ou la couche isolante du dispositif.

### EXPOSÉ DE L'INVENTION

L'invention a donc tout d'abord pour but de proposer un dispositif d'actionnement électrostatique miniature apte à générer des mouvements dans une direction déterminée, le dispositif comprenant au moins un couple d'électrodes séparées par une couche isolante et dont l'une d'entre elles est susceptible de se déplacer, le dispositif remédiant au moins partiellement aux inconvénients mentionnés ci-dessus relatifs aux réalisations de l'art antérieur.

L'invention a plus précisément pour but de présenter un dispositif de conception simplifiée et de coût amoindri par rapport aux dispositifs d'actionnement connus de l'art antérieur.

Par ailleurs, l'invention a en outre pour but de proposer une installation comprenant une pluralité de dispositifs d'actionnement électrostatique miniatures, tels que ceux répondant également au but de l'invention mentionné ci-dessus.

Pour ce faire, l'invention a pour objet un dispositif d'actionnement électrostatique miniature apte à générer des mouvements dans une direction déterminée, le dispositif comprenant au moins un couple d'électrodes séparées par une couche isolante, chaque couple d'électrodes étant constitué d'une électrode fixe solidaire d'un support du dispositif ainsi que d'une électrode mobile dont au moins une portion est située à distance de l'électrode fixe lorsque le dispositif se trouve dans un état non-activé, le dispositif étant apte à être activé par l'intermédiaire d'une tension électrique appliquée entre les deux électrodes de chaque couple entraînant un plaquage de l'électrode mobile contre l'électrode fixe sur une surface de plaquage variable en fonction de la tension appliquée entre les deux électrodes. Selon l'invention, le dispositif comprend de plus un organe d'actionnement relié à la portion de chaque électrode mobile située à distance de l'électrode fixe associée, l'organe d'actionnement étant susceptible d'occuper une position de repos lorsque le dispositif se trouve dans un état non-activé et d'être déplacé de façon guidée dans la direction déterminée lors d'une variation de la tension appliquée entre les deux électrodes de chaque couple, le dispositif comportant en outre au moins un bras de rappel apte à rappeler l'organe d'actionnement vers sa position de repos, lors d'une diminution de la tension appliquée entre les deux électrodes de chaque couple d'électrodes.

Le dispositif d'actionnement miniature selon l'invention présente l'ensemble des avantages liés à l'« effet zipping » mis en oeuvre entre chaque couple d'électrodes du dispositif, à savoir la quasi-linéarité entre le déplacement de l'organe d'actionnement et la tension appliquée entre les électrodes de chaque couple d'électrodes, la course importante de l'organe d'actionnement, ainsi que la grande force développée lors des mouvements de cet organe d'actionnement.

De plus, le dispositif comporte également des moyens mécaniques simples permettant de remettre en place l'organe d'actionnement dans sa position de repos, suite à une phase d'activation du dispositif. Ces moyens sont constitués par au moins un bras de rappel susceptible de générer une force opposée à la force électrostatique créée entre les électrodes de chaque couple d'électrodes. De cette façon, il est facilement possible de concevoir un dispositif dont le ou les bras de rappel provoquent une force supérieure à la force électrostatique générée lorsque la tension appliquée descend en dessous d'une valeur prédéterminée, ceci entraînant par conséquent le replacement automatique de l'organe d'actionnement dans sa position de repos.

En outre, lors d'une simple diminution de la tension appliquée entre les électrodes de chaque couple d'électrodes, la force électrostatique engendrée faiblit, de sorte que le ou les bras de rappel prévus sont facilement capables de rappeler l'organe d'actionnement vers sa position de repos, le rappel étant stoppé lorsque la force électrostatique engendrée est supérieure à la force créée par chaque bras de rappel.

Selon un mode de réalisation, chaque bras de rappel est apte à travailler en traction et en flexion, et selon un autre mode de réalisation, est porté par un élément de support de chaque bras de rappel, ce dernier étant solidaire du support du dispositif.

De plus, le dispositif peut être conçu, selon un autre mode de réalisation, de manière à ce que, lorsque l'organe d'actionnement est dans sa position de repos, l'intégralité de l'électrode mobile de chaque couple d'électrodes est maintenue à distance de l'électrode fixe par l'intermédiaire de chaque bras de rappel, l'électrode mobile comprenant une première extrémité constituée par la portion reliée à l'organe d'actionnement, ainsi qu'une seconde extrémité constituée par une zone d'amorçage apte à être plaquée contre l'électrode fixe lors de l'application d'une tension d'amorçage entre les deux électrodes. Ainsi, dans une telle configuration, les électrodes mobiles peuvent être réalisées de manière à être sensiblement planes, et ne rencontrent par conséquent plus le besoin d'incorporer des formes complexes en trois dimensions pour disposer d'une partie en contact avec l'électrode fixe et d'une partie à distance de cette dernière lorsque le dispositif n'est pas activé, comme cela était le cas dans l'art antérieur. La réalisation des électrodes mobiles est donc fortement facilitée, et peut par exemple être effectuée par un procédé de photolithogravure, par découpage laser dans une plaque fine de matériau électriquement conducteur.

On peut également prévoir, selon un autre mode de réalisation, que, pour chaque couple d'électrodes, l'électrode mobile comprend un bras courbé dans un plan sensiblement orthogonal à la direction déterminée de déplacement de l'organe d'actionnement, le bras courbé étant relié d'une part à l'organe d'actionnement du dispositif, et d'autre part à la zone d'amorçage de l'électrode mobile.

Avantageusement, la courbure pratiquée sur les électrodes mobiles permet au dispositif d'actionnement miniature de disposer d'une forte compacité, tout en autorisant à l'organe d'actionnement d'être déplacé selon une course de longueur très importante.

Selon un autre mode de réalisation de la présente invention, décrit dans la revendication 6, l'organe d'actionnement est apte à être guidé dans la direction déterminée de déplacement par l'intermédiaire de moyens de guidage en translation de l'organe d'actionnement, couplés au dispositif. Notons que ces moyens sont prévus dans la mesure où le mouvement transmis à l'organe d'actionnement par l'une quelconque des électrodes mobiles subissant un plaquage est un mouvement dont la trajectoire n'est pas rectiligne. Ces moyens de guidage ont donc pour but de transformer le mouvement complexe créé à l'extrémité de l'électrode mobile, en un mouvement de translation dans la direction déterminée.

Selon un autre mode de réalisation, l'organe d'actionnement est apte à être guidé dans la direction déterminée de déplacement par l'intermédiaire d'une pluralité de couples d'électrodes comportant une électrode fixe commune de forme sensiblement plane et des électrodes mobiles disposées symétriquement par rapport à l'organe d'actionnement, la direction déterminée de déplacement de l'organe d'actionnement étant alors sensiblement orthogonale à l'électrode fixe.

En raison de la symétrie opérée entre les différentes électrodes mobiles reliées à l'organe d'actionnement du dispositif, les mouvements transmis à ce dernier se compensent partiellement pour donner lieu à un mouvement selon une direction unique déterminée, sensiblement orthogonale à l'électrode fixe.

Le dispositif d'actionnement peut comprendre, selon un autre mode de réalisation, quatre couples d'électrodes dont les électrodes mobiles sont identiques et réparties à 90° autour de l'organe d'actionnement, de manière à s'inscrire dans un espace évidé de section carrée formé dans l'élément de support de chaque bras de rappel du dispositif.

Selon un autre mode de réalisation de la présente invention, les électrodes mobiles ont une zone d'amorçage en forme de disque, et un bras courbé en forme de couronne circulaire s'étendant sensiblement tout autour de la zone d'amorçage.

Selon un autre mode de réalisation de la présente invention, les électrodes mobiles ont une zone d'amorçage en forme de rectangle et un bras courbé en forme de L incurvé.

Selon un autre mode de réalisation de la présente invention, le dispositif comprend trois couples d'électrodes dont les électrodes mobiles sont identiques et conçues de manière à s'inscrire dans un espace évidé de section hexagonale formé dans l'élément de support de chaque bras de rappel du dispositif. Les électrodes mobiles ont alors préférentiellement une zone d'amorçage s'étendant sur un secteur d'environ 120° en bordure d'une paroi intérieure de l'espace évidé de section hexagonale, la zone d'amorçage se prolongeant par un bras courbé en forme de spirale.

De manière préférentielle et pour chacun des modes de réalisation décrits ci-dessus, chaque bras de rappel est également solidaire de l'un des éléments pris parmi le groupe constitué de l'organe d'actionnement et de la portion de l'électrode mobile reliée à l'organe d'actionnement de chaque couple d'électrodes.

De plus, on peut prévoir, selon un autre mode de réalisation, que l'élément de support de chaque bras de rappel, l'organe d'actionnement, l'électrode mobile de chaque couple d'électrodes et chaque bras de rappel du dispositif sont réalisés d'un seul tenant, et selon un autre mode de réalisation, dans un matériau électriquement conducteur.

Enfin, il est également possible que, selon un autre mode de réalisation, pour chaque couple d'électrodes, l'organe d'actionnement et l'électrode mobile sont reliés au moyen d'une liaison élastique, permettant d'absorber les déplacements parasites parallèles à l'électrode fixe, entre l'électrode mobile et l'organe d'actionnement du dispositif.

L'invention a en outre pour objet, selon un autre mode de réalisation, une installation comprenant une pluralité de dispositifs d'actionnement électrostatique miniatures tels que ceux décrits ci-dessus et également objet de l'invention, les dispositifs étant juxtaposés les uns aux autres et disposant d'un support commun.

D'autres avantages et caractéristiques de l'invention apparaîtront dans la description détaillée non limitative ci-dessous.

### BRÈVE DESCRIPTION DES DESSINS

Cette description sera faite au regard des dessins annexés parmi lesquels ;
- la figure 1 représente une vue schématique en perspective d'un dispositif d'actionnement électrostatique miniature selon un premier mode de réalisation préféré de la présente invention, lorsque ce dispositif se trouve dans un état non-activé ;
- les figures 2a à 2d représentent des vues schématiques en coupe du dispositif d'actionnement représenté sur la figure 1, dans différentes configurations expliquant le fonctionnement de ce dispositif ;
- la figure 3 est un graphe représentant le déplacement de l'organe d'actionnement du dispositif représenté sur la figure 1, en fonction de la tension électrique appliquée entre les deux électrodes du dispositif ;
- la figure 4 représente une vue schématique en perspective d'un dispositif d'actionnement électrostatique miniature selon un second mode de réalisation préféré de la présente invention, lorsque ce dispositif se trouve dans un état non-activé ;
- la figure 5 représente une vue schématique en perspective d'un dispositif d'actionnement électrostatique miniature selon un troisième mode de réalisation préféré de la présente invention, lorsque ce dispositif se trouve dans un état non-activé ;
- la figure 6 représente une vue schématique en perspective d'un dispositif d'actionnement électrostatique miniature selon un quatrième mode de réalisation préféré de la présente invention, lorsque ce dispositif se trouve dans un état non-activé ; et
- la figure 7 représente une vue schématique en perspective d'une installation selon un mode de réalisation préféré de la présente invention, comprenant une pluralité de dispositifs d'actionnement électrostatique miniatures, tels que ceux représentés sur la figure 4.

### EXPOSÉ DÉTAILLÉ DE MODES DE RÉALISATION PRÉFÉRÉS

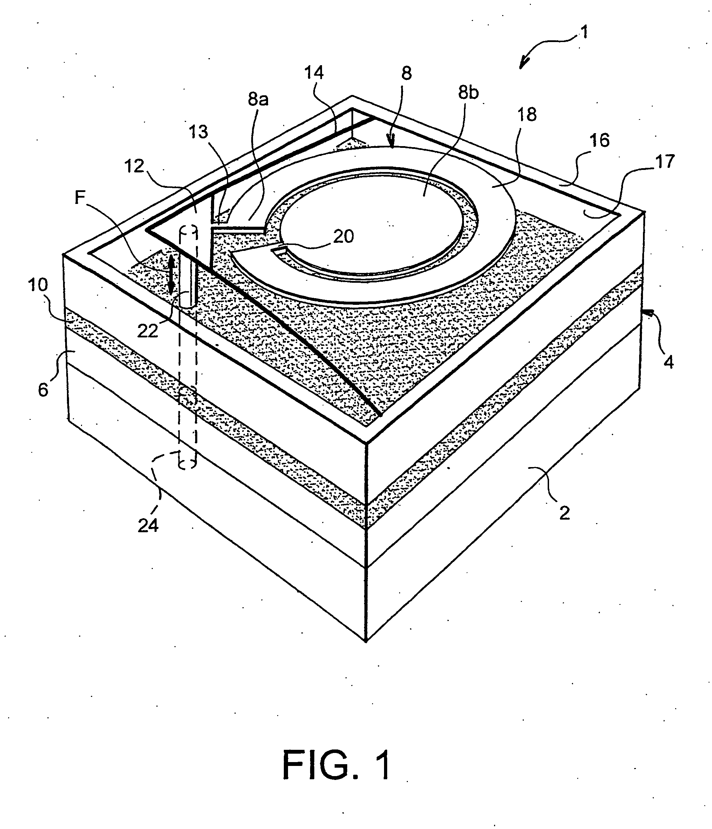

La figure 1 illustre un dispositif 1 d'actionnement électrostatique miniature selon un premier mode de réalisation préféré de la présente invention, le dispositif 1 étant destiné à générer des mouvements dans une direction déterminée symbolisée par la flèche F.

Le dispositif 1 comporte un support 2 sur lequel repose un couple d'électrodes 4. Le couple d'électrodes 4 comporte une électrode fixe 6 sensiblement plane et horizontale, et solidaire du support 2 du dispositif 1. En outre, le couple d'électrodes 4 comprend également une électrode mobile 8 dont au moins une portion est située à distance de l'électrode fixe 6, lorsque le dispositif 1 se trouve dans un état non-activé (figure 1).

Dans ce premier mode de réalisation préféré, lorsque le dispositif 1 est dans un état non-activé, l'électrode mobile 8 est sensiblement plane et se situe dans son intégralité à distance de l'électrode fixe 6, sensiblement parallèlement à cette dernière. Notons que l'électrode fixe 6 est revêtue d'une couche isolante 10 interdisant le contact direct entre l'électrode fixe 6 et l'électrode mobile 8, lors d'une phase d'activation du dispositif 1 (décrite ultérieurement). Bien entendu, la couche isolante 10 pourrait également être prévue sur l'électrode mobile 8 du dispositif 1.

Le dispositif 1 d'actionnement miniature comporte un organe d'actionnement 12 tel qu'une plaquette mobile, relié à une première extrémité 8a de l'électrode mobile 8 par l'intermédiaire d'une liaison élastique 13, cet organe d'actionnement 12 étant destiné à décrire des mouvements dans la direction déterminée F, correspondant sensiblement à une direction orthogonale à l'électrode fixe 6 et au support 2 du dispositif 1. Il est précisé que dans un état non-activé du dispositif 1, l'organe d'actionnement 12 s'étend de préférence dans le même plan que l'électrode mobile 8.

Dans l'état non-activé représenté sur la figure 1, à savoir lorsque aucune tension n'est appliquée entre les deux électrodes 6 et 8 du dispositif 1, l'électrode mobile 8 est maintenue à distance de l'électrode fixe 6 par l'intermédiaire d'au moins un bras de rappel 14 s'étendant longitudinalement et sensiblement parallèlement à l'électrode fixe 6. Chacun des bras de rappel 14 a en outre pour fonction de maintenir l'organe d'actionnement 12 dans une position de repos, correspondant à une position dans laquelle l'organe 12 est également situé à distance de l'électrode fixe 6 du dispositif 1.

Les bras de rappel 14, susceptibles de travailler en flexion et en traction, sont de préférence au nombre de deux. Ces bras 14 sont reliés d'une part à l'organe d'actionnement 12 et d'autre part à un élément de support 16 solidaire de la couche isolante 10 et dans lequel est prévu un espace évidé 17 apte à recevoir l'électrode mobile 8. Dans le mode de réalisation présenté, les bras de rappel 14 sont disposés l'un par rapport à l'autre de manière à former un angle d'une valeur approximative de 90°. Sans sortir du cadre de l'invention, il est également possible de prévoir que l'élément de support 16 soit directement fixé sur le support 2 du dispositif 1.

Toujours en référence à la figure 1, l'électrode mobile 8 du dispositif 1 comporte en outre une seconde extrémité constituée par une zone d'amorçage 8b, apte à être plaquée contre l'électrode fixe 6 lors de l'application d'un tension d'amorçage, par l'intermédiaire de moyens (non représentés) d'application d'une tension entre les deux électrodes 6 et 8.

De façon préférée, l'électrode mobile 8 est constituée de la zone d'amorçage 8b ainsi que d'un bras courbé 18 relié à la zone d'amorçage 8b au moyen d'une liaison souple 20, le bras courbé 18 s'étendant jusqu'à la première extrémité 8a connectée à l'organe d'actionnement 12. Notons que la courbure du bras 18 est réalisée dans un plan sensiblement orthogonal à la direction déterminée F de déplacement de l'organe d'actionnement 12.

Par ailleurs, le dispositif d'actionnement 1 comporte des moyens de guidage en translation 22,24 de l'organe d'actionnement 12, afin de permettre un déplacement de ce dernier de façon guidée dans la direction déterminée F, suite à la transmission d'un mouvement depuis la première extrémité 8a de l'électrode mobile 8. A titre d'exemple, les moyens de guidage 22,24 peuvent prendre la forme d'une tige de guidage 22 solidaire de l'organe d'actionnement 12 et apte à coulisser dans un alésage 24 d'axe parallèle à la direction déterminée F, cet alésage 24 traversant un ou plusieurs éléments du dispositif 1 tels que la couche isolante 10, l'électrode fixe 6, ou encore le support 2.

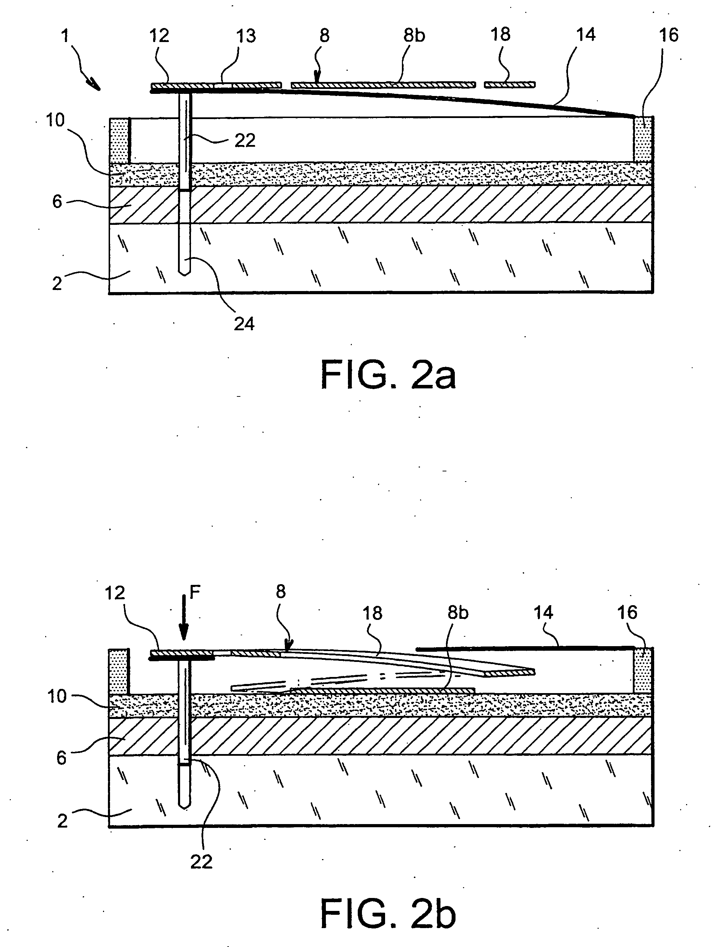

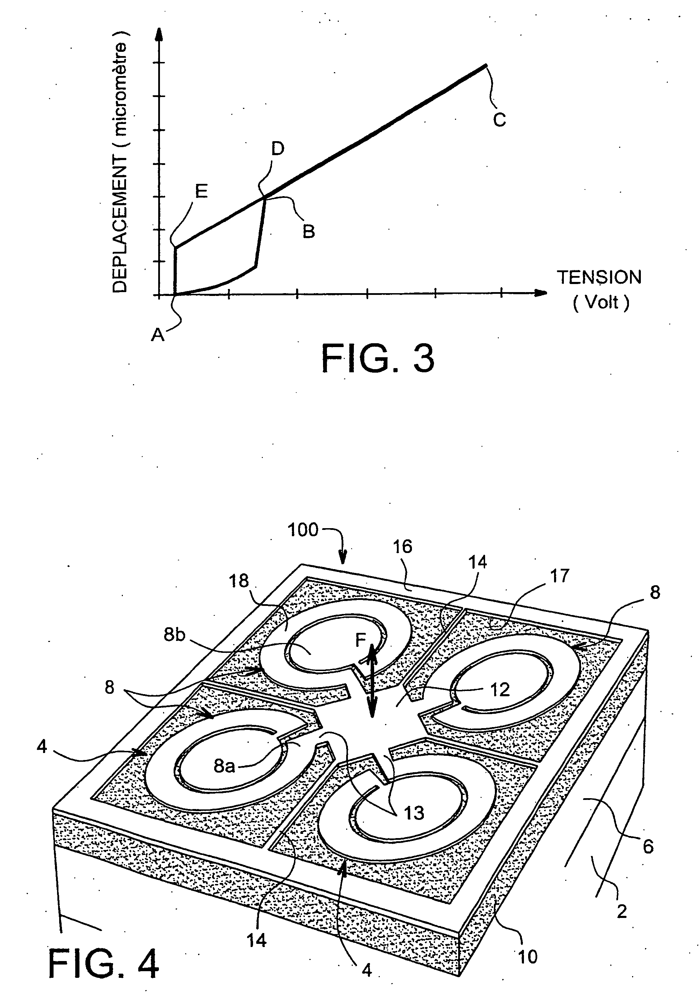

Le fonctionnement du dispositif 1 d'actionnement miniature va à présent être décrit, en référence aux figures 2a à 2d, et à la figure 3 représentant un graphe dont l'axe des abscisses correspond à la tension en Volts appliquée entre les deux électrodes 6 et 8, et dont l'axe des ordonnées correspond à la distance en micromètres à laquelle se trouve l'organe d'actionnement 12 de sa position de repos.

La figure 2a illustre le dispositif d'actionnement 1 dans un état non-activé, identique à l'état représenté sur la figure 1.

La tension électrique appliquée entre les deux électrodes 6 et 8 est donc nulle, et l'ensemble constitué de l'électrode mobile 8 et de l'organe d'actionnement 12 est entièrement maintenu à distance de l'électrode fixe 6, par l'intermédiaire des bras de rappel 14 du dispositif 1. Comme cela a été rappelé ci-dessus, notons que dans cet état symbolisé par le point A du graphe de la figure 3, l'organe d'actionnement 12 du dispositif 1 occupe sa position de repos.

Lors de l'application d'une tension entre les électrodes 6 et 8, une force électrostatique se crée entre ces celles-ci, et provoque le déplacement de la zone d'amorçage 8b de l'électrode mobile 8 en direction de l'électrode fixe 6. Au fur et mesure que la tension appliquée augmente, l'organe d'actionnement 12 est également légèrement déplacé vers l'électrode fixe 6, jusqu'à ce que la tension atteigne une tension d'amorçage engendrant le plaquage brusque de la zone d'amorçage 8b contre l'électrode fixe 6. Ce plaquage brusque de la zone d'amorçage 8b, comparable à l'effet « pull-in » rencontré dans les dispositifs d'actionnement électrostatique classiques de l'art antérieur, provoque un déplacement de l'organe d'actionnement 12 très significatif par rapport aux déplacements observés lors de l'application de tensions inférieures. Il est précisé que le déplacement de l'électrode mobile 8, engendré par la force électrostatique créée entre les deux électrodes 6 et 8, est autorisé par la souplesse de cette électrode 8 lui permettant de se déformer dans une direction sensiblement parallèle à la direction F de déplacement de l'organe 12, ainsi que par la déformation en traction et en flexion des bras de rappel 14. De plus, le mouvement transmis à l'organe d'actionnement 12 est transformé en un mouvement de translation à l'aide de la tige de guidage 22 et de l'alésage 24, la liaison élastique 13 permettant quant à elle d'absorber les mouvements parasites perpendiculaires à la direction F entre l'électrode mobile 8 et l'organe d'actionnement 12.

L'état du dispositif 1 dans lequel la zone d'amorçage 8b vient d'être plaquée contre l'électrode fixe 6 est représenté sur la figure 2b, et correspond au point B du graphe de la figure 3. Notons que sans sortir du cadre de l'invention, il est également possible de prévoir une électrode mobile 8 de forme initiale telle que celle représentée sur la figure 2b, dans laquelle l'une de ses extrémités serait initialement plaquée contre l'électrode fixe 6, et l'autre de ses extrémités serait située à distance de cette dernière.

L'électrode 8 peut être réalisée par un empilement d'au moins deux couches de matériaux de coefficients de dilatation différents. La forme « incurvée » telle que représentée sur la figure 2b peut ainsi être obtenue en effectuant un traitement thermique adapté pour produire un effet bilame.

A titre d'exemple, la tension d'amorçage requise pour le plaquage de la zone d'amorçage 8b contre l'électrode fixe 6 est de 30V, tandis que la distance parcourue par l'organe d'actionnement 12 depuis sa position de repos et suite au plaquage de la zone d'amorçage 8b est de 6µm.

Suite au plaquage de la zone d'amorçage 8b de l'électrode mobile 8, le dispositif 1 accède à un état dans lequel on obtient une relation linéaire entre la tension appliquée et le déplacement de l'organe d'actionnement 12.

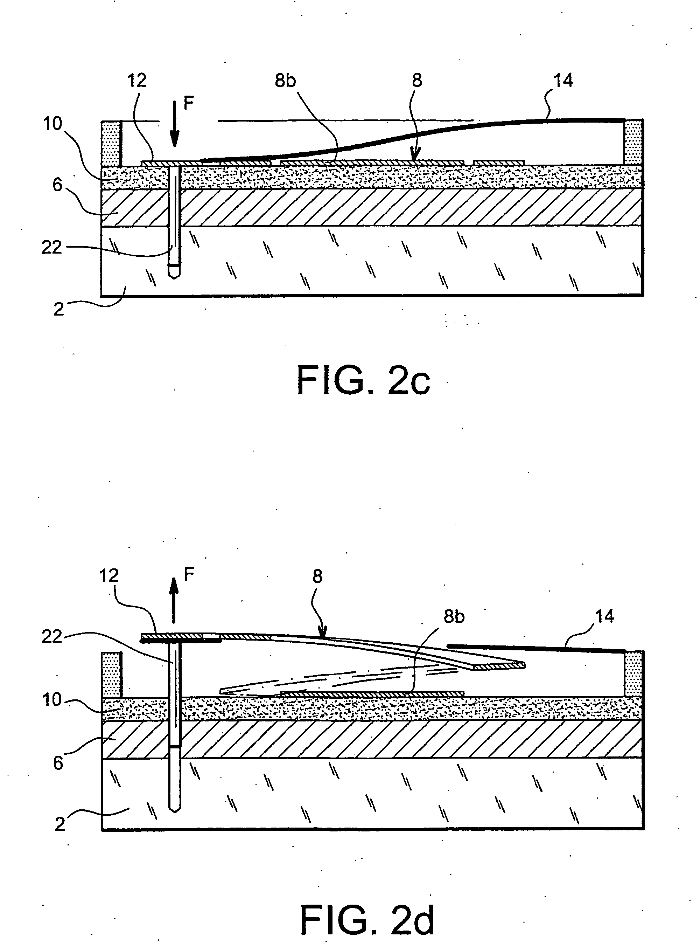

Ainsi, une augmentation de la tension provoque un plaquage progressif du bras courbé 18 de l'électrode mobile 8 contre l'électrode fixe 6, la surface de plaquage entre ces deux électrodes 6 et 8 étant variable en fonction de la tension appliquée entre celles-ci, conformément au principe de 1'« effet zipping ». Cette augmentation peut être opérée jusqu'à ce que l'organe d'actionnement 12 vienne en contact avec la couche isolante 10 contre l'électrode fixe 6, toujours grâce à la déformation des bras de rappel 14, de la liaison 13, et de la souplesse de l'électrode mobile 8. Cet état d'activation maximale du dispositif 1 est représenté sur la figure 2c, et correspond au point C du graphe de la figure 3. Notons que pour faciliter le contact entre la couche isolante 10 et l'organe d'actionnement 12, il est possible d'adapter la géométrie de cet organe 12, et de prévoir une zone non-conductrice telle qu'un trou en dessous de cet organe.

Toujours à titre d'exemple, le déplacement maximal de l'organe d'actionnement 12 peut s'élever à 12µm, tandis que la tension à appliquer pour obtenir une telle course est inférieure à 100V. De plus, notons que la force développée par le déplacement de l'électrode mobile 8 est de l'ordre de 100µN, contre environ 1 µN dans les réalisations de l'art antérieur.

Lorsque le dispositif d'actionnement 1 se trouve dans l'état d'activation maximale, la tension appliquée entre les deux électrodes 6 et 8 peut être diminuée afin d'entraîner un déplacement de l'organe d'actionnement 12 en direction de sa position de repos, grâce à l'action mécanique de rappel exercée par les bras de rappel 14. En effet, la diminution de la tension appliquée provoque une baisse de la force électrostatique entre les deux électrodes 6 et 8, de sorte qu'une portion de l'électrode mobile 8 n'est plus soumise à cette force électrostatique, et peut être décollée de l'électrode fixe 6 sous l'action de bras de rappel 14. Ainsi, l'organe d'actionnement 12 est rappelé vers sa position de repos, le rappel étant stoppé lorsque la force électrostatique engendrée par la tension appliquée en fin de diminution est supérieure à la force développée par les bras de rappel 14.

Durant la diminution de la tension, la même relation linéaire que celle observée durant l'augmentation de la tension est alors conservée, de sorte que lorsque la tension appliquée est diminuée jusqu'à la tension d'amorçage, le dispositif 1 se trouve dans un état symbolisé par le point D sur le graphe de la figure 3, ce point D étant sensiblement confondu avec le point B de ce même graphe.

Cependant, on observe également une conservation de la linéarité lorsque la tension appliquée descend en dessous de la tension d'amorçage. Cette linéarité est maintenue jusqu'à ce que la tension appliquée soit abaissée à une valeur prédéterminée (figure 2d et point E du graphe de la figure 3). En dessous de cette valeur prédéterminée, les bras de rappel 14 génèrent une force supérieure à la force électrostatique créée entre les électrodes 6 et 8, entraînant par conséquent la remise en place de l'organe d'actionnement 12 dans sa position de repos.

Il est précisé que la tension prédéterminée correspondant au point E sur la figure 3, s'élevant par exemple à quelques Volts seulement, est calculée en fonction des paramètres techniques des divers éléments constituant le dispositif 1.

Ainsi, lorsque le dispositif miniature 1 se trouve dans un état symbolisé par le point E sur le graphe de la figure 3, il peut subir une augmentation de tension provoquant son rétablissement dans la zone de variation linéaire située entre les points E et C, ou bien subir une diminution de la tension entraînant la remise en place de l'organe d'actionnement 12 dans sa position de repos, par l'intermédiaire des bras de rappel 14.

A titre d'exemple, la zone linéaire située entre les points E et C du graphe de la figure 3 peut correspondre à une course maîtrisée verticale de l'organe d'actionnement 12 d'environ 11µm. Un micro-système quelconque (non représenté) peut alors être actionné par l'organe d'actionnement 12 sur une même distance.

En référence à la figure 4, il est représenté un dispositif 100 d'actionnement électrostatique miniature selon un second mode de réalisation de la présente invention, ce dispositif 100 étant destiné à générer des mouvements dans une direction déterminée symbolisée par la flèche F.

Le dispositif 100 représenté est relativement similaire au dispositif 1 du premier mode de réalisation préféré décrit ci-dessus, à la différence qu'il comporte quatre couples d'électrodes 4 au lieu d'un seul, et qu'il ne dispose plus de moyens de guidage en translation 22,24.

En effet, le dispositif 100 comprend quatre couples d'électrodes 4 comportant une électrode fixe commune 6 plane et revêtue d'une couche isolante 10, l'électrode fixe 6 étant solidaire d'un support 2 du dispositif 100. Les quatre électrodes mobiles 8 sont identiques à celle décrite dans le premier mode de réalisation préféré, et sont disposées symétriquement à 90° autour d'un organe d'actionnement 12 auquel chacune des ces électrodes 8 est reliée par l'intermédiaire d'une liaison élastique 13.

Les électrodes mobiles 8 s'inscrivent dans un espace évidé 17 de section carrée, formé dans un élément de support 16 des bras de rappel 14, également de section carrée. Dans ce second mode de réalisation préféré, les bras de rappel 14 sont au nombre de quatre, et s'étendent sensiblement longitudinalement et parallèlement à l'électrode fixe 6, depuis chacun des côtés de l'élément de support 16 formant cadre autour des électrodes mobiles 8, jusqu'à l'organe d'actionnement 12 situé au centre de l'espace évidé 17 de section carrée. De cette façon, chaque bras de rappel 14 est positionné de manière à ce qu'il se trouve entre deux électrodes mobiles 8 du dispositif 100.

Comme on peut le voir sur la figure 4, la zone d'amorçage 8b de chaque électrode mobile 8 a une forme de disque, et le bras courbé 18 a une forme de couronne circulaire s'étendant sensiblement tout autour de la zone d'amorçage 8b en forme de disque. En outre, il est précisé que les électrodes mobiles 8 sont positionnées dans l'espace évidé 17 de sorte que chaque bras courbé 18 en forme de couronne circulaire se situe à proximité de deux côtés directement consécutifs de l'élément de support 16 formant le cadre.

Dans ce second mode de réalisation, l'avantage réside dans la possibilité de fabriquer les bras de rappel 14, les électrodes mobiles 8, l'élément de support 16, ainsi que l'organe d'actionnement 12 d'un seul tenant et dans un matériau électriquement conducteur, par des techniques analogues à celles de la micro-électronique. Ainsi, il est relativement aisé d'appliquer la même tension à chacun des couples d'électrodes 4, afin de générer un déplacement identique de chacune des électrodes mobiles 8, et d'obtenir par conséquent un déplacement de l'organe d'actionnement 12 selon la direction déterminée F orthogonale à l'électrode fixe 6 et au support 2 du dispositif 1.

De plus, il est indiqué que les électrodes mobiles 8 peuvent être alimentées de façon commune ou séparée, sans sortir du cadre de l'invention.

Le fonctionnement du dispositif 100 est similaire à celui du dispositif 1 du premier mode de réalisation préféré, à la différence que la symétrie des électrodes mobiles 8 par rapport à l'organe d'actionnement 12 permet de s'exonérer de la présence des moyens de guidage en translation de ce dernier. En effet, lorsque les électrodes mobiles 8 sont mises en mouvement suite à leur plaquage contre l'électrode commune fixe 6, la première extrémité 8a des électrodes mobiles 8 transmet un mouvement à l'organe d'actionnement 12, ce mouvement se décomposant en une translation selon la direction déterminée F, et en une translation selon une direction perpendiculaire à la direction déterminée F. Ainsi, en raison de la conception symétrique du dispositif 100 et de la tension identique appliquée à chacun des couples d'électrodes 4, les translations selon les directions perpendiculaires à la direction déterminée F ainsi que d'autres mouvements tels que ceux de basculement et de rotation sont aptes à se compenser mutuellement, de sorte que le mouvement résultant de l'organe d'actionnement 12 s'effectue uniquement selon la direction déterminée F sensiblement orthogonale à l'électrode fixe 6.

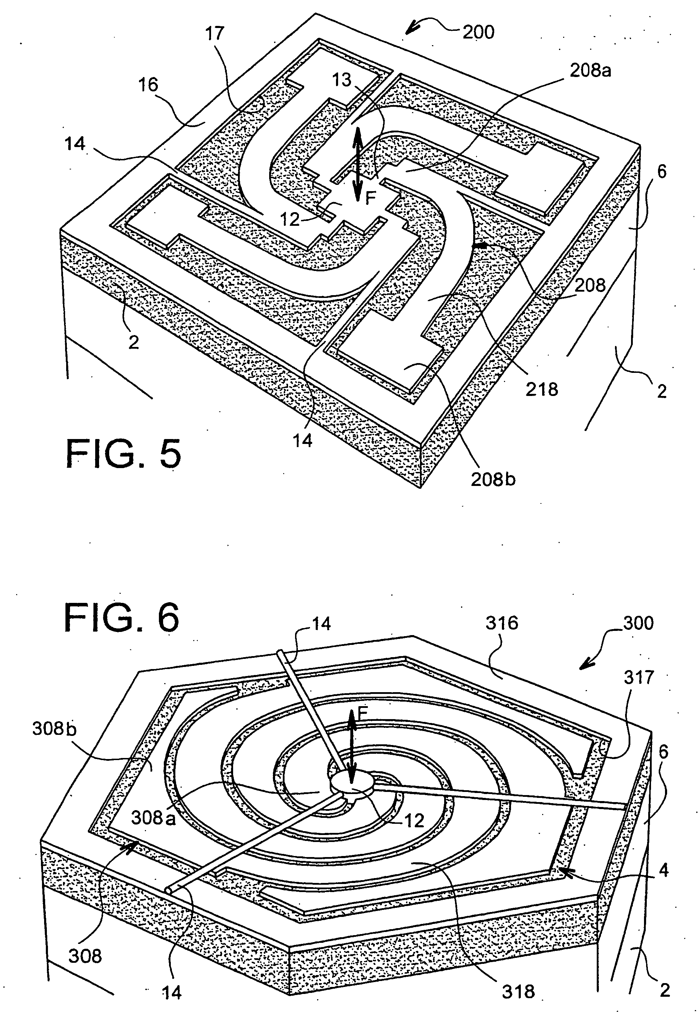

En référence à la figure 5, il est représenté un dispositif 200 d'actionnement électrostatique miniature selon un troisième mode de réalisation de la présente invention, ce dispositif 200 étant destiné à générer des mouvements dans une direction déterminée symbolisée par la flèche F.

Le dispositif 200 est relativement similaire au dispositif 100 du second mode de réalisation décrit ci-dessus, à la différence que les quatre électrodes mobiles 208 sont conçues différemment des électrodes mobiles 8 du second mode de réalisation.

Les électrodes mobiles 208 sont en effet toutes identiques, et comprennent chacune une première extrémité 208a reliée à l'organe d'actionnement 12 du dispositif 200. Un bras courbé 218 s'étend depuis cette première extrémité 208a, en prenant la forme d'un L incurvé. De plus, une zone d'amorçage 208b en forme de rectangle se trouve à l'autre extrémité du bras courbé 218. Comme on peut le voir sur la figure 5, chaque zone d'amorçage 208b en forme de rectangle est positionnée à proximité d'un angle droit de l'espace évidé 17 de section carrée pratiqué dans l'élément de support 16 formant cadre autour des électrodes mobiles 208, de manière à sensiblement épouser cet angle droit.

Par ailleurs, une particularité de ce troisième mode de réalisation de la présente invention réside dans le fait que chaque bras de rappel 14 est raccordé d'une part à l'élément de support 16, et d'autre part à la première extrémité 208a d'une électrode mobile 208. Ainsi, le replacement de l'organe d'actionnement 12 à l'aide des bras de rappel 14 s'effectue par déplacement des électrodes mobiles 208, et non plus directement par déplacement de l'organe d'actionnement 12. Bien entendu, cette possibilité de conception est envisageable pour l'ensemble des modes de réalisation proposés.

En référence à la figure 6, il est représenté un dispositif 300 d'actionnement électrostatique miniature selon un quatrième mode de réalisation de la présente invention, ce dispositif 300 étant destiné à générer des mouvements dans une direction déterminée symbolisée par la flèche F.

Le dispositif 300 est relativement similaire aux dispositifs 100 et 200 des second et troisième modes de réalisation décrits ci-dessus, à la différence qu'il comporte un élément de support 316 et des électrodes mobiles 308 de formes différentes.

En effet, l'élément de support 316 des bras de rappel 14 est de forme sensiblement hexagonale, et comprend un espace évidé 317 de section également hexagonale. De plus le dispositif 300 comprend trois électrodes mobiles 308, chacune comportant une première extrémité 308a reliée à l'organe d'actionnement 12 du dispositif 300. Un bras courbé 318 s'étend depuis cette première extrémité 308a, en prenant la forme d'une spirale. De plus, une zone d'amorçage 308b s'étendant sur un secteur d'environ 120° en bordure d'une paroi intérieure de l'espace évidé 317 se trouve à l'autre extrémité du bras courbé 318.

Dans ce quatrième mode de réalisation de la présente invention fonctionant de façon similaire à celle des second et troisième modes de réalisation décrits, le dispositif 300 comporte trois bras de rappel 14 disposés et raccordés à 120° autour de l'organe d'actionnement 12, dans un plan légèrement surélevé par rapport au plan dans lequel se trouvent les électrodes mobiles 308 des couples d'électrodes 4.

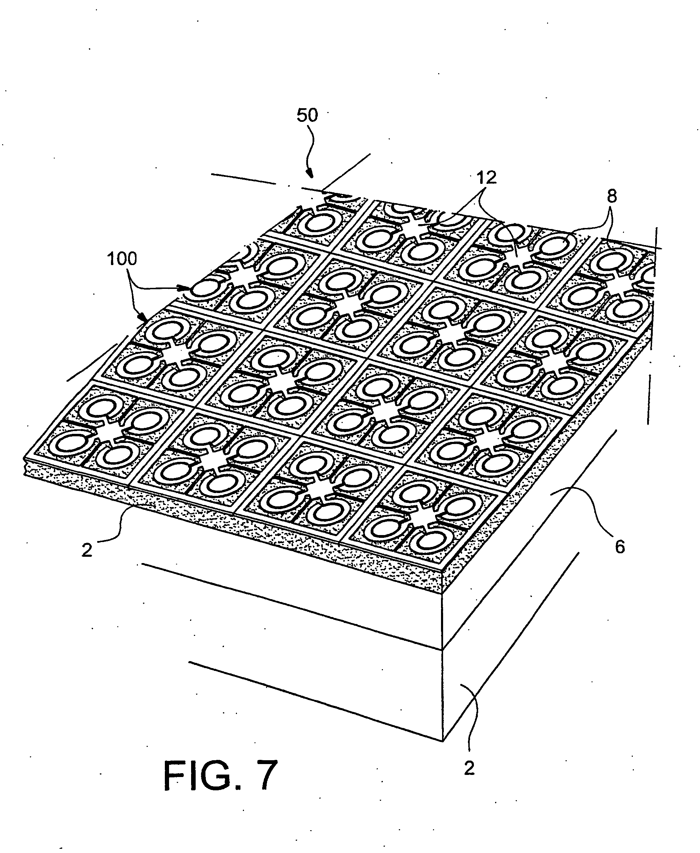

En outre, l'invention se rapporte également à une installation 50 représentée sur la figure 7, cette installation 50 comprenant une pluralité de dispositifs d'actionnement électrostatique miniatures 100 tels que celui décrit dans le second mode de réalisation de la présente invention. Bien entendu, l'installation 50 peut être constituée d'une pluralité de dispositifs d'actionnement selon l'un quelconque des modes de réalisation décrits précédemment, sans sortir du cadre de l'invention.

Comme cela est visible sur la figure 7, les dispositifs 100 sont juxtaposés les uns aux autres. Notons que la juxtaposition des dispositifs 100 est autorisée grâce aux formes extérieures complémentaires des ces dispositifs 100, permettant l'assemblage de ces derniers les uns aux autres de manière à ce qu'ils forment une surface continue. A titre d'exemple et en référence aux modes de réalisation décrits ci-dessus, la forme extérieure des dispositifs d'actionnement miniatures peut être carrée ou hexagonale.

Ainsi, l'installation 50 présente une multitude d'organes d'actionnement 12 disposés les uns à côté des autres, permettant par exemple d'accueillir et de commander un micro-miroir déformable en continu (non représenté).

Dans un autre mode de réalisation, on pourra également prévoir que l'installation 50 comprenne un support 2 commun aux divers dispositifs 100. Il est alors possible que l'élément de support 16 des dispositifs 100, l'organe d'actionnement 12 des dispositifs 100, l'électrode mobile 8 de chaque couple d'électrodes 4 des dispositifs 100, et chaque bras de rappel 14 des dispositifs 100 soient réalisés d'un seul tenant, de sorte que l'ensemble de la partie supérieure de l'installation 50 puisse être effectué en une seule opération. En procédant ainsi, il n'est alors plus nécessaire de réaliser l'assemblage des dispositifs 100 les uns aux autres, ces derniers étant réalisés de manière simultanée.

Bien entendu, diverses modifications peuvent être apportées par l'homme du métier aux dispositifs 1,100,200,300 et à l'installation 50 qui viennent d'être décrits.

## Revendications

1. Dispositif (1,100,200,300) d'actionnement électrostatique miniature apte à générer des mouvements dans une direction déterminée (F), ledit dispositif (1,100,200,300) comprenant au moins un couple d'électrodes (4) séparées par une couche isolante (10), chaque couple d'électrodes (4) étant constitué d'une électrode fixe (6) solidaire d'un support (2) dudit dispositif ainsi que d'une électrode mobile (8,208,308) dont au moins une portion est située à distance de l'électrode fixe (6) lorsque le dispositif se trouve dans un état non-activé, le dispositif (1,100,200,300) étant apte à être activé par l'intermédiaire d'une tension électrique appliquée entre les deux électrodes (6,8,208,308) de chaque couple (4) entraînant un plaquage de l'électrode mobile (8,208,308) contre l'électrode fixe (6) sur une surface de plaquage variable en fonction de la tension appliquée entre les deux électrodes (6,8,208,308), **caractérisé en ce que** le dispositif (1,100,200,300) comprend de plus un organe d'actionnement (12) relié à ladite portion de chaque électrode mobile (8,208,308) située à distance de l'électrode fixe associée (6), l'organe d'actionnement (12) étant arrangé de manière à occuper une position de repos lorsque le dispositif se trouve dans un état non-activé et être déplacé de façon guidée dans la direction déterminée (F) lors d'une variation de la tension appliquée entre les deux électrodes (6,8,208,308) de chaque couple (4), ledit dispositif comportant en outre au moins un bras de rappel (14) apte à rappeler l'organe d'actionnement (12) vers sa position de repos, lors d'une diminution de la tension appliquée entre les deux électrodes (6,8,208,308) de chaque couple d'électrodes (4).

2. Dispositif (1,100,200,300) d'actionnement selon la revendication 1, **caractérisé en ce que** chaque bras de rappel (14) est apte à travailler en traction et en flexion.

3. Dispositif (1,100,200,300) d'actionnement selon la revendication 1 ou la revendication 2, **caractérisé en ce qu'**il comprend un élément de support (16,316) de chaque bras de rappel (14), ledit élément (16,316) étant solidaire du support (2) dudit dispositif.

4. Dispositif (1,100,200,300) d'actionnement selon l'une quelconque des revendications 1 à 3, **caractérisé en ce que** lorsque l'organe d'actionnement (12) est dans sa position de repos, l'intégralité de l'électrode mobile (8,208,308) de chaque couple d'électrodes (4) est maintenue à distance de l'électrode fixe (6) par l'intermédiaire de chaque bras de rappel (14), l'électrode mobile (8,208,308) comprenant une première extrémité (8a,208a,308a) constituée par la portion reliée à l'organe d'actionnement (12), ainsi qu'une seconde extrémité constituée par une zone d'amorçage (8b,208b,308b) apte à être plaquée contre l'électrode fixe (6) lors de l'application d'une tension d'amorçage entre les deux électrodes (6,8,208,308).

5. Dispositif (1,100,200,300) d'actionnement selon la revendication 4, **caractérisé en ce que** pour chaque couple d'électrodes (4), l'électrode mobile (8,208,308) comprend un bras courbé (18,218,318) dans un plan sensiblement orthogonal à la direction déterminée de déplacement (F) de l'organe d'actionnement (12), ledit bras courbé (18,218,318) étant relié d'une part à l'organe d'actionnement (12) dudit dispositif, et d'autre part à la zone d'amorçage (8b,208b,308b) de ladite électrode mobile (8,208,308).

6. Dispositif (1) d'actionnement selon l'une quelconque des revendications précédentes, **caractérisé en ce que** l'organe d'actionnement (12) est apte à être guidé dans la direction déterminée de déplacement (F) par l'intermédiaire de moyens de guidage en translation (22,24) de l'organe d'actionnement (12) couplés audit dispositif (1).

7. Dispositif (100,200,300) d'actionnement selon l'une quelconque des revendications 1 à 5, **caractérisé en ce que** l'organe d'actionnement (12) est apte à être guidé dans la direction déterminée de déplacement (F) par l'intermédiaire d'une pluralité de couples d'électrodes (4) comportant une électrode fixe commune (4) de forme sensiblement plane et ayant leurs électrodes mobiles (8,208,308) disposées symétriquement par rapport à l'organe d'actionnement (12), la direction déterminée (F) de déplacement de l'organe d'actionnement (12) étant alors sensiblement orthogonale à l'électrode fixe (6).

8. Dispositif (100,200) d'actionnement selon la revendication 7, **caractérisé en ce qu'**il comprend quatre couples d'électrodes (4) dont les électrodes mobiles (8,208) sont identiques et réparties à 90° autour de l'organe d'actionnement (12), de manière à s'inscrire dans un espace évidé (17) de section carrée formé dans l'élément de support (16) de chaque bras de rappel (14) dudit dispositif.

9. Dispositif (100) d'actionnement selon la revendication 8 et la revendication 4 combinées, **caractérisé en ce que** les électrodes mobiles (8) ont une zone d'amorçage (8b) en forme de disque, et un bras courbé (18) en forme de couronne circulaire s'étendant sensiblement tout autour de la zone d'amorçage (8b).

10. Dispositif (200) d'actionnement selon la revendication 8 et la revendication 4 combinées, **caractérisé en ce que** les électrodes mobiles (208) ont une zone d'amorçage (208b) en forme de rectangle et un bras courbé (218) en forme de L incurvé.

11. Dispositif (300) d'actionnement selon la revendication 7, **caractérisé en ce qu'**il comprend trois couples d'électrodes (4) dont les électrodes mobiles (308) sont identiques et conçues de manière à s'inscrire dans un espace évidé (317) de section hexagonale formé dans l'élément de support (316) de chaque bras de rappel (14) dudit dispositif.

12. Dispositif (300) d'actionnement selon la revendication 11 et la revendication 4 combinées, **caractérisé en ce que** les électrodes mobiles (308) ont une zone d'amorçage (308b) s'étendant sur un secteur d'environ 120° en bordure d'une paroi intérieure de l'espace évidé (317) de section hexagonale, ladite zone d'amorçage (308b) se prolongeant par un bras courbé (318) en forme de spirale.

13. Dispositif (1,100,200,300) d'actionnement selon l'une quelconque des revendications précédentes, **caractérisé en ce que** pour chaque couple d'électrodes (4), la couche isolante (10) se situe sur l'une quelconque des deux électrodes (6,8,208,308).

14. Dispositif (1,100,200,300) d'actionnement selon l'une quelconque des revendications précédentes, **caractérisé en ce que** chaque bras de rappel (14) est également solidaire de l'un des éléments pris parmi le groupe constitué de l'organe d'actionnement (12) et de la portion de l'électrode mobile (8,208,308) reliée à l'organe d'actionnement (12) de chaque couple d'électrodes (4).

15. Dispositif (1,100,200,300) d' actionnement selon l'une quelconque des revendications précédentes, **caractérisé en ce que** l'élément de support (16,316) de chaque bras de rappel (14), l'organe d'actionnement (12), l'électrode mobile (8,208,308) de chaque couple d'électrodes (4) et chaque bras de rappel (14) dudit dispositif sont réalisés d'un seul tenant.

16. Dispositif (1,100,200,300) d'actionnement selon l'une quelconque des revendications précédentes, **caractérisé en ce que** chaque bras de rappel (14) dudit dispositif est réalisé dans un matériau électriquement conducteur.

17. Dispositif (1,100,200,300) d'actionnement selon l'une quelconque des revendications précédentes, **caractérisé en ce que** pour chaque couple d'électrodes (4), l'organe d'actionnement (12) et l'électrode mobile (8,208,308) sont reliées au moyen d'une liaison élastique (13).

18. Installation (50) comprenant une pluralité de dispositifs (100) d'actionnement électrostatique miniatures, **caractérisée en ce que** les dispositifs (100) sont des dispositifs d'actionnement électrostatique miniatures selon l'une quelconque des revendications précédentes, lesdits dispositifs (100) étant juxtaposés les uns aux autres et disposant d'un support (2) commun.

19. Installation (50) selon la revendication 18, **caractérisée en ce que** chacun des dispositifs (100) d'actionnement électrostatique miniatures comprend un élément de support (16) de chaque bras de rappel (14), et **en ce que** l'élément de support (16) des dispositifs, l'organe d'actionnement (12) des dispositifs, l'électrode mobile (8) de chaque couple d'électrodes (4) des dispositifs, et chaque bras de rappel (14) des dispositifs sont réalisés d'un seul tenant.

## Patentansprüche

1. Elektrostatische Mikroantriebsvorrichtung (1,100,200,300), fähig Bewegungen in einer bestimmte Richtung (F) zu erzeugen, wobei diese Vorrichtung (1,100,200,300) wenigstens ein durch eine Isolierschicht (10) getrenntes Elektrodenpaar (4) umfasst, jedes Elektrodenpaar (4) gebildet wird durch eine mit einem Träger (2) der genannten Vorrichtung verbundene feste Elektrode (6) sowie eine bewegliche Elektrode (8,208,308), von der wenigstens ein Teil von der festen Elektrode (6) beabstandet ist, wenn die Vorrichtung sich in einem nichtaktivierten Zustand befindet, wobei diese Vorrichtung (1,100,200,300) aktiviert werden kann durch eine zwischen den beiden Elektroden (6,8,208,308) jedes Paars (4) angelegte elektrische Spannung, die bewirkt, dass die bewegliche Elektrode (8,208,308) gegen die feste Elektrode (6) gepresst wird, wobei die Pressfläche variabel ist in Abhängigkeit von der zwischen den beiden Elektroden (6,8,208,308) angelegten Spannung,
**dadurch gekennzeichnet, dass** die Vorrichtung (1,100,200,300) außerdem ein Betätigungsorgan (12) umfasst, verbunden mit dem genannten, von der zugeordneten festen Elektrode (6) beabstandeten Teil jeder beweglichen Elektrode (8,208,308), wobei das Betätigungsorgan (12) so konzipiert ist, dass es, wenn die Vorrichtung sich in einem nichtaktivierten Zustand befindet, eine Ruhestellung einnimmt, aber bei einer Veränderung der zwischen den beiden Elektroden (6,8,208,308) jedes Paars (4) angelegten Spannung in der festgelegten Richtung (F) verschoben wird, in geführter Weise, wobei die genannte Vorrichtung außerdem wenigstens einen Rückstellarm (14) umfasst, fähig das Betätigungsorgan (12) wieder in Richtung Ruhestellung zu schieben, wenn die zwischen den beiden Elektroden (6,8,208,308) jedes Elektrodenpaars (4) angelegte Spannung abnimmt.

2. Antriebsvorrichtung (1,100,200,300) nach Anspruch 1, **dadurch gekennzeichnet, dass** jeder Rückstellarm (14) fähig ist, mit Zug und mit Biegung zu arbeiten.

3. Antriebsvorrichtung (1,100,200,300) nach Anspruch 1 oder Anspruch 2, **dadurch gekennzeichnet, dass** sie ein Tragelement (16,316) jedes Rückstellarms (14) umfasst, wobei das genannte Element (16,316) fest mit dem Träger (2) der genannten Vorrichtung verbunden ist.

4. Antriebsvorrichtung (1,100,200,300) nach einem der Ansprüche 1 bis 3, **dadurch gekennzeichnet, dass** - wenn das Betätigungsorgan (12) sich in seiner Ruhestellung befindet -, die gesamte bewegliche Elektrode (8,208,308) jedes Elektrodenpaars (4) durch jeden Rückstellarm (14) auf Abstand von der festen Elektrode (6) gehalten wird, wobei die bewegliche Elektrode (8,208,308) ein erstes Ende (8a,208a,308a) umfasst, gebildet durch den mit dem Betätigungsorgan (14) verbundenen Teil, sowie ein zweites Ende, das durch eine Auslösungszone (8b,208b308b) gebildet wird, die gegen die feste Elektrode (6) gepresst wird, wenn zwischen den beiden Elektroden (6,8,208,308) eine Betätigungsspannung angelegt wird.

5. Antriebsvorrichtung (1,100,200,300) nach Anspruch 4, **dadurch gekennzeichnet, dass** bei jedem Elektrodenpaar (4) die bewegliche Elektrode (8,208,308) einen gebogenen Arm (8,218,318) in einer im Wesentlichen zu der festgelegten Verschiebungsrichtung (F) des Betätigungsorgans (12) senkrechten Ebene umfasst, wobei der gebogene Arm (8,218,318) einerseits mit dem Betätigungsorgan (12) der genannten Vorrichtung und andererseits mit der Auslösungszone (8b,208b,308b) der genannten beweglichen Elektrode (8,208,308) verbunden ist.

6. Antriebsvorrichtung (1) nach einem der vorangehenden Ansprüche, **dadurch gekennzeichnet, dass** die genannte Vorrichtung (1) Führungseinrichtungen (22,24) zur geführten Parallelverschiebung des Betätigungsorgans (12) in der festgelegten Richtung (F) umfasst.

7. Antriebsvorrichtung (100,200,300) nach einem der Ansprüche 1 bis 5, **dadurch gekennzeichnet, dass** das Betätigungsorgan (12) geführt werden kann durch eine Vielzahl von Elektrodenpaaren (4) mittels einer im Wesentlichen planen festen Elektrode (6) und zum Betätigungsorgan (12) symmetrisch angeordneter beweglicher Elektroden (8,208,308), wobei die festgelegte Verschiebungsrichtung (F) des Betätigungsorgans (12) dann im Wesentlichen senkrecht zu der festen Elektrode (6) ist.

8. Antriebsvorrichtung (100,200) nach Anspruch 7, **dadurch gekennzeichnet, dass** sie vier Elektrodenpaare (4) umfasst, deren bewegliche Elektroden (8,208) identisch sind und um jeweils 90° um das Betätigungsorgan (12) herum so verteilt sind, dass sie in einem quadratischen Raum (17) enthaltenen sind, der in dem Tragelement (16) jedes Rückstellarms (14) der genannten Vorrichtung ausgespart ist.

9. Antriebsvorrichtung (100) nach Anspruch 8 und Anspruch 4 kombiniert, **dadurch gekennzeichnet, dass** die beweglichen Elektroden (8) eine scheibenförmige Auslösungszone (8b) und einen ringförmig gebogenen kreisrunden Arm (18) aufweisen, der sich im Wesentlichen um die gesamte Auslösungszone (8b) herum erstreckt.

10. Antriebsvorrichtung (200) nach Anspruch 8 und Anspruch 4 kombiniert, **dadurch gekennzeichnet, dass** die beweglichen Elektroden (208) eine rechteckige Auslösungszone (208b) und einen L-förmig gebogenen Arm (218) aufweisen.

11. Antriebsvorrichtung (300) nach Anspruch 7, **dadurch gekennzeichnet, dass** sie drei Elektrodenpaare (4) umfasst, deren bewegliche Elektroden (308) identisch sind und so konzipiert, dass sie enthalten sind in einem Raum (317) mit hexagonalem Querschnitt, ausgespart in dem Tragelement (316) jedes Rückstellarms (14) der genannten Vorrichtung.

12. Antriebsvorrichtung (300) nach Anspruch 11 und Anspruch 4 kombiniert, **dadurch gekennzeichnet, dass** die beweglichen Elektroden (308) eine Auslösungszone (308b) haben, die sich über einen Sektor von ungefähr 120° längs einer Innenwand des ausgesparten Raums (317) mit hexagonalem Querschnitt erstrecken, wobei die genannte Auslösungszone (308b) durch einen spiralförmig gebogenen Arm (318) verlängert wird.

13. Antriebsvonichtung (1,100,200,300) nach einem der vorangehenden Ansprüche, **dadurch gekennzeichnet, dass** sich bei jedem Elektrodenpaar (4) die Isolierschicht (10) auf einer der beiden Elektroden (6,8,208,308) befindet.

14. Antriebsvorrichtung (1,100,200,300) nach einem der vorangehenden Ansprüche, **dadurch gekennzeichnet, dass** der Rückstellarm auch fest mit einem der Elemente der Gruppe verbunden ist, die gebildet wird durch das Betätigungsorgan (12) und den Teil der beweglichen Elektrode (8,208,308), der mit dem Betätigungsorgan (12) jedes Elektrodenpaars (4) verbunden ist.

15. Antriebsvorrichtung (1,100,200,300) nach einem der vorangehenden Ansprüche, **dadurch gekennzeichnet, dass** das Tragelement (16,316) jedes Rückstellarms (14), das Betätigungselement (12), die bewegliche Elektrode (8,208,308) jedes Elektrodenpaars (4) und jeder Rückstellarm (14) der genannten Vorrichtung aus einem Stück sind.

16. Antriebsvorrichtung (1,100,200,300) nach einem der vorangehenden Ansprüche, **dadurch gekennzeichnet, dass** jeder Rückstellarm (14) der genannten Vorrichtung aus einem elektrisch leitfähigen Material ist.

17. Antriebsvorrichtung (1,100,200,300) nach einem der vorangehenden Ansprüche, **dadurch gekennzeichnet, dass** das Betätigungsorgan (12) und die bewegliche Elektrode (8,208,308) jedes Elektrodenpaars (4) mittels einer elastischen Verbindung (13) verbunden sind.

18. Installation (50) mit einer Vielzahl elektrostatischer Mikroantriebsvorrichtungen (100), **dadurch gekennzeichnet, dass** die Vorrichtungen (100) elektrostatische Mikroantriebsvorrichtungen nach einem der vorangehenden Ansprüche sind, wobei die genannten Vorrichtungen (100) aneinandergefügt sind und über einen gemeinsamen Träger (2) verfügen.

19. Installation (50) nach Anspruch 18, **dadurch gekennzeichnet, dass** jede der elektrostatischen Mikroantriebsvorrichtungen (100) ein Tragelement (16) jedes Rückstellarms (14) umfasst, und **dadurch**, dass das Tragelement (16) der Vorrichtungen, das Betätigungsorgan (12) der Vorrichtungen, die bewegliche Elektrode (8) jedes Elektrodenpaars der Vorrichtungen und jeder Rückstellarm (14) der Vorrichtungen aus einem Stück sind.

## Claims

1. Miniature electrostatic actuation device (1, 100, 200, 300) capable of generating movements along a determined direction (F), said device (1, 100, 200, 300) comprising at least one pair of electrodes (4) separated by an insulating layer (10), each pair of electrodes (4) being composed of a fixed electrode (6) attached to a support (2) of said device and a mobile electrode (8, 208, 308), at least one portion of which is located at a distance from the fixed electrode (6) when the device is in an inactive state, the device (1, 100, 200, 300) being capable of being activated by means of an electrical voltage applied between the two electrodes (6, 8, 208, 308) in each pair (4) causing the mobile electrode (8, 208, 308) to be pulled into contact with the fixed electrode (6) on a variable pull-in surface that varies as a function of the voltage applied between the two electrodes (6, 8, 208, 308),
**characterized in that** the device (1, 100, 200, 300) also comprises an actuation element (12) connected to said portion of each mobile electrode (8, 208, 308) located at a distance from the associated fixed electrode (6), the actuation element (12) arranged so as to occupy a rest position when the device is in an inactive state, be guided along the determined direction (F) when the voltage applied between the two electrodes (6, 8, 208, 308) in each pair (4) varies, said device also comprising at least one return arm (14) capable of pulling the actuation element (12) back towards its rest position when the voltage applied between the two electrodes (6, 8, 208, 308) in each pair of electrodes (4) is reduced.

2. Actuation device (1, 100, 200, 300) according to claim 1, **characterized in that** each return arm (14) can work in tension or in bending.

3. Actuation device (1, 100, 200, 300) according to claim 1 or claim 2, **characterized in that** it includes a support element (16, 316) for each return arm (14), said element (16, 316) being fixed to the support (2) of said device.

4. Actuation device (1, 100, 200, 300) according to any one of claims 1 to 3, **characterized in that** when the actuation element (12) is in its rest position, the entire mobile electrode (8, 208, 308) of each pair of electrodes (4) is kept at a distance from the fixed electrode (6) by each return arm (14), the mobile electrode (8, 208, 308) comprising the portion connected to the actuation element (12), and a second end composed of a priming area (8b, 208b, 308b) that may be pulled into contact with the fixed electrode (6) when a priming voltage is applied between the two electrodes (6, 8, 208, 308).

5. Actuation device (1, 100, 200, 300) according to claim 4, **characterized in that** the mobile electrode (8, 208, 308) of each pair of electrodes (4) comprises a curved arm (18, 218, 318) in a plane approximately orthogonal to the determined direction of displacement (F) of the actuation element (12), said curved arm (18, 218, 318) being connected firstly to the actuation element (12) of said device, and secondly to the priming area (8b, 208b, 308b) of said mobile electrode (8, 208, 308).

6. Actuation device (1) according to any one of the previous claims, **characterized in that** the actuation element (12) can be guided along the determined displacement direction (F) using means providing translation guidance (22, 24) of the actuation element (12) coupled to said device (1).

7. Actuation device (100, 200, 300) according to any one of claims 1 to 5, **characterized in that** the actuation element (12) may be guided along the determined displacement direction (F) through a plurality of electrode pairs (4) comprising a common fixed electrode (4) with an approximately plane shape and mobile electrodes (8, 208, 308) arranged symmetrically with respect to the actuation element (12), the determined direction of displacement (F) of the actuation element (12) then being approximately orthogonal to the fixed electrode (6).

8. Actuation device (100, 200) according to claim 7, **characterized in that** it comprises four pairs of electrodes (4) in which the mobile electrodes (8, 208) are identical and are distributed at 90° around the actuation element (12), to be inscribed in a hollowed out space (17) with a square cross section formed in the support element (16) of each return arm (14) of said device.

9. Actuation device (100) according to combined claims 8 and 4, **characterized in that** the mobile electrodes (8) have a disk shaped priming area (8b), and an arm (18) curved in the shape of a circular ring extending approximately all the way around the priming area (8b).

10. Actuation device (200) according to claims 8 and 4 combined, **characterized in that** the mobile electrodes (208) have a rectangular shaped priming area (208b) and a curved L-shaped arm (218).

11. Actuation device (300) according to claim 7, **characterized in that** it comprises three pairs of electrodes (4), in which the mobile electrodes (308) are identical and are designed to be inscribed within a hollowed out space (317) with a hexagonal section formed in the support element (316) of each return arm (14) of said device.

12. Actuation device (300) according to claims 11 and 4 combined, **characterized in that** the mobile electrodes (308) are arranged to have a priming area (308b) extending over a sector covering about 120° around the edge of an internal wall in the hollowed out space (317) with a hexagonal section, said priming area (308b) being prolonged by a spiral curved arm (318).

13. Actuation device (1, 100, 200, 300) according to any one of the previous claims, **characterized in that** any one of the two electrodes (6, 8, 208, 308) is coated with the insulating layer (10).

14. Actuation device (1, 100, 200, 300) according to any one of the previous claims, **characterized in that** each return arm (14) is also fixed to one of the elements among the group composed of the actuation element (12) and the portion of the mobile electrode (8, 208, 308) connected to the actuation element (12) of each pair of electrodes (4).

15. Actuation device (1, 100, 200, 300) according to any one of the previous claims, **characterized in that** the support element (16, 316) of each return arm (14), the actuation element (12), the mobile electrode (8, 208, 308) in each pair of electrodes (4) and each return arm (14) of said device are made in a single piece.

16. Actuation device (1, 100, 200, 300) according to any one of the previous claims, **characterized in that** each return arm (14) of said device is made from an electrically conducting material.

17. Actuation device (1, 100, 200, 300) according to any one of the previous claims, **characterized in that** for each pair of electrodes (4), the actuation element (12) and the mobile electrode (8, 208, 308) are connected by means of an elastic connection (13).

18. Installation (50) comprising a plurality of miniature electrostatic actuation devices (100), **characterized in that** the devices (100) are miniature electrostatic actuation devices according to any one of the previous claims, said devices (100) being adjacent to each other and provided with a common support (2).

19. Installation (50) according to claim 18, **characterized in that** each of the miniature electrostatic actuation devices (100) comprises a support element (16) for each return arm (14), and **in that** the support element (16) of the devices, the actuation element (12) of the devices, the mobile electrode (8) of each pair of electrodes (4) of the devices, and each return arm (14) of the devices are made in a single piece.
